# EUROPEAN PATENT APPLICATION

(11) **EP 3 153 904 A2**
(43) Date of publication of application: **12.04.2017**
(21) Application number: 16191833.9
(22) Date of filing: 30.09.2016
(51) Int. Cl.: G02B 19/00, F21V 5/04

(54) **ILLUMINATION MODULE FOR CREATING SPECIFIC LATERAL RECTANGULAR ILLUMINATION WINDOW**

(30) Priority: 07.10.2015 TW 104133326; 05.01.2016 TW 105100254
(71) Applicant: Ligitek Electronics Co., Ltd., New Taipei City (TW)
(72) Inventor: LEE, Hsiao-Wen, Taoyuan City (TW); TUNG, I-Hsin, New Taipei City (TW)
(74) Representative: Casalonga

(57) **Abstract**

An illumination module for creating specific lateral rectangular illumination window includes a substrate, at least one light-emitting element, and an optical lens. The at least one light-emitting element is mounted on the substrate for generating visible light or invisible light. The optical lens is arranged on the substrate to encapsulate the at least one light-emitting element. The optical lens includes a light-exiting surface with a light emission center, which can be configured to direct a beam of light generated by the light-emitting element to travel along with the optical axis and pass through the light emission center and emit outwards to create a lateral rectangular illumination window. Whereby, components of a camera can be reduced, and distortion caused by compressing and converting an image can be prevented by utilizing the invention.

## Description

### BACKGROUND OF THE INVENTION

### 1. Field of the Invention

The instant disclosure relates to an illumination module, in particular, to an illumination module for creating specific lateral rectangular illumination window.

### 2. Description of Related Art

Nowadays, surveillance cameras are very widely used in places such as factories, dormitories, stores, buildings, and gateways of community housings, or secret areas, to monitor human activities and save information under light (including visible light or invisible light) emitting by the surveillance cameras for the uses of trace and authentication. Thereby, those who having bad intentions will be threaten and warned against the illegal acts, and thus the public can be ensured from crimes.

A common problem of the surveillance cameras is poor lighting at night time. In the surveillance cameras there is arranged infrared rays LED (Light Emitting Diode) or laser illumination device to assist image capture. Thus, the surveillance cameras can start monitoring under poor lighting environment (such as interior space or night-time occasion). In general, the range of the wavelength of the light emitted by the infrared rays LED is approximately 750 to 1000 nm and the range of the wavelength of the laser beam is approximately 800 to 1000 nm, which all are invisible to the naked eye. These invisible lights can provide sufficient far distance illumination.

The output illumination pattern generated by LED or laser illumination device is circular symmetric, and the intensity in the central region is always greater than that in the peripheral region. This may result in an unclear shooting position on the peripheral of the target object.

Further, to match a special image aspect ratio (such as 4:3 or 16:9) captured by the camera, the conventional lens mechanism usually have a rectangular opening with an aspect ratio of 4:3 or 16:9, thus the captured image of the target object can be converted to a lateral rectangular image electrical signal using a photoelectric conversion unit. In addition, the light illumination range, window, and aspect ratio of the illumination device cannot meet the standard 4:3 aspect ratio of imaging apparatus or the standard 16:9 aspect ratio of high definition TV (HDTV). Thus, there is always some distortion of the captured image of the target object.

Furthermore, the light source generates illumination pattern. The images of the target object are compressed into the image frames with a preset aspect ratio via an image server. The compressed image frames may not capture artifacts which may display at different positions in the image frame generated by compressing the images of the target object. Thus, this results from that the video image displayed on TV or monitor after image decompression is the artifact.

In summary, there is an urgent need of technologies used to convert a circular symmetric illumination pattern generated by visible light or invisible light into an asymmetric illumination pattern with an aspect ratio of 4:3 or 16:9.

### SUMMARY OF THE INVENTION

The inventor adjusts the angle of the light pattern to solve the aforementioned problems. The object of the instant disclosure is to provide an illumination module for creating specific lateral rectangular illumination window, which achieves max results with little effort without substantial light losses, and the extra volume.

In order to achieve the aforementioned objects, according to an embodiment of the instant disclosure, the illumination module includes a substrate, at least one light-emitting element, and an optical lens. The substrate includes an installation surface. The light-emitting element is mounted on the installation surface of substrate, and having an optical axis. The optical lens is mounted on the installation surface of substrate to encapsulate the light-emitting element, wherein the optical lens has no air gap with the substrate and the light-emitting element and is an asymmetric and transparent material. The optical lens includes a light-entrance surface and a light-exiting surface opposite to the light-entrance surface, wherein the length extending direction of the light-entrance surface is an X axial direction, the width extending direction of the light-entrance surface is a Y axial direction which is perpendicular to the X axial direction, and a direction perpendicular to the light-entrance surface is a Z axial direction. The light-exiting surface of the optical lens is formed by at least two curves of different curvature, and has a light emission center. The light-exiting surface of the optical lens is configured to direct a beam of light generated by the light-emitting element to travel along with the optical axis and pass through the light emission center and emit outwards to create a lateral rectangular illumination window, wherein the lateral rectangular illumination window has an aspect ratio between 1.03 and 2.08.

In one embodiment, the aspect ratio is between 1.03 and 1.63 or between 1.48 and 2.08.

In one embodiment, the light-emitting element is configured to generate a white light having a color temperature ranging from approximately 2700K to 7000K.

In one embodiment, the light-emitting element is a LED.

In one embodiment, the light-emitting element is configured to generate an infrared light having a wavelength ranging from approximately 750 to 1000 nm.

In one embodiment, the light-emitting element is configured to generate an infrared light having a wavelength ranging from 790 to 830 nm or 830 to 870 nm.

In one embodiment, the light-emitting element is configured to generate an infrared light having a wavelength ranging from 900 to 1000 nm.

In one embodiment, the light-emitting element is an infrared emitting diode.

In one embodiment, the light-emitting element is a laser element configured to generate a laser beam having a wavelength ranging from approximately 800 to 1000 nm.

In one embodiment, the laser element is a laser diode.

In one embodiment, the amount of the light-emitting element is one and the shape of the light-emitting element is square.

In one embodiment, the amount of the light-emitting element is plurality and the light-emitting elements are arranged in an illuminate array, the shape of which is non-rectangular array.

In one embodiment, the illuminate array is arranged in a square shape.

In one embodiment, the substrate is a metal substrate, a ceramic substrate, or a glass fiber substrate.

In one embodiment, the metal substrate is selected from the materials including copper, copper alloy, aluminum, aluminum alloy, magnesium alloy, aluminum silicon carbide, and carbon composition.

In one embodiment, the ceramic substrate is selected from the materials including aluminum oxide, aluminum nitride, zirconium oxide, silicon carbide, hexagonal boron nitride, and fluorinated carbon.

In one embodiment, the optical lens has no air gap with the substrate and the light-emitting element and is a transparent material.

In one embodiment, the optical lens is asymmetric.

In one embodiment, the light-exiting surface of the optical lens is an aspheric surface, a cambered surface, a paraboloid surface, a hyperboloid surface, or a free-form surface.

In one embodiment, the light-exiting surface is a free-form surface or a hyperboloid surface, the light distribution pattern in the X axial direction is the contour of the bat wings, the half-power angle of which is smaller than 160 degrees, and the light distribution pattern in the Y axial direction is the contour of the light-concentrating or the bat wings, the half-power angle of which is smaller than 120 degrees.

In one embodiment, the light-exiting surface of the optical lens is a free-form surface or a hyperboloid surface, the light distribution pattern in the X axial direction is the contour of the bat wings, the half-power angle of which is smaller than 140 degrees, and the light distribution pattern in the Y axial direction is the contour of the light-concentrating or the bat wings, the half-power angle of which is smaller than 100 degrees.

In one embodiment, the optical lens is selected from epoxy, acrylic resin, silicon resin, and silicone.

The benefits of the present invention mention as below. The invention is implemented in the surveillance camera system. The invention can create a specific lateral rectangular illumination window having an aspect ratio of between 1.03 and 1.63 or an aspect ratio of between 1.48 and 2.08. Thereby, rectangular images can be directly captured by a camera, and the peripheral of the target object can be clearly shot. In addition, the components of the camera can be reduced, and distortion caused by compressing and converting the image can be prevented.

In order to further appreciate the characteristics and technical contents of the instant disclosure, references are hereunder made to the detailed descriptions and appended drawings in connection with the instant disclosure. However, the appended drawings are merely shown for exemplary purposes, rather than being used to restrict the scope of the instant disclosure.

### BRIEF DESCRIPTION OF THE DRAWINGS

FIG. 1 is a perspective view showing an illumination module for creating specific lateral rectangular illumination window according to a first embodiment of the present invention;
FIG. 2a is a sectional view (1) showing an illumination module for creating specific lateral rectangular illumination window according to the first embodiment of the present invention;
FIG. 2b is a sectional view (2) showing an illumination module for creating specific lateral rectangular illumination window according to the first embodiment of the present invention;
FIG. 3 is a perspective view showing an illumination module for creating specific lateral rectangular illumination window according to a second embodiment of the present invention;
FIG. 4 is a perspective view showing an illumination module for creating specific lateral rectangular illumination window according to a third embodiment of the present invention;
FIG. 5a is a polar luminous intensity distribution diagram (1) showing an illumination module for creating specific lateral rectangular illumination window according to the third embodiment of the present invention; and
FIG. 5b is a polar luminous intensity distribution diagram (2) showing an illumination module for creating specific lateral rectangular illumination window according to the third embodiment of the present invention.

### DETAILED DESCRIPTION OF THE PREFERRED EMBODIMENTS

The aforementioned illustrations and following detailed descriptions are exemplary for the purpose of further explaining the scope of the instant disclosure. Other objectives and advantages related to the instant disclosure will be illustrated in the subsequent descriptions and appended drawings.

### First embodiment

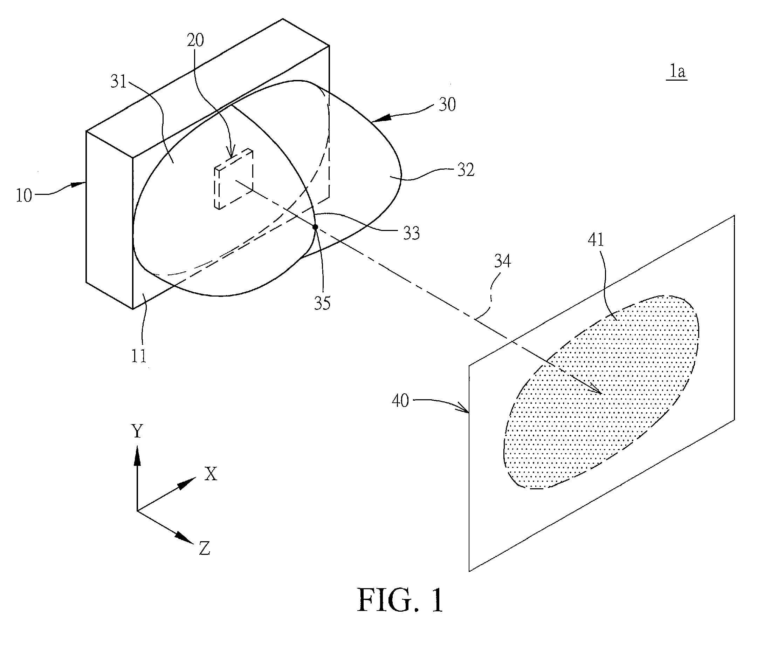

Please refer to FIG. 1. This is a perspective view showing an illumination module for creating specific lateral rectangular illumination window according to a first embodiment of the present invention. As shown in FIG. 1, the illumination module 1a includes a substrate 10, a light-emitting element 20, and an optical lens 30.

The substrate 10 includes an installation surface 11 for arrangement of the light-emitting element 20. For the instant embodiment, the substrate 10 can be but not limited to a metal substrate, a ceramic substrate, or a glass fiber substrate (e.g., FR-4, FR-5, G-10, G-11, and so on). Specifically, the metal substrate can be selected from the materials including copper, copper alloy, aluminum, aluminum alloy, magnesium alloy, aluminum silicon carbide, and carbon composition. The ceramic substrate can be selected from one of the materials including aluminum oxide, aluminum nitride, zirconium oxide, silicon carbide, hexagonal boron nitride, and fluorinated carbon. Preferably, on a surface opposite to the installation surface 11 of the substrate 10 there can be arranged a heat sink (not shown) to dissipate heat from the light-emitting element 20, wherein the heat sink can be made by die-casting, aluminum extruding, or punching.

The light-emitting element 20 is mounted on the substrate 10. The shape of the light-emitting element 20 is square and the light-emitting element 20 has an optical axis 34. For the instant embodiment, the amount of the light-emitting element 20 is one and the light-emitting element 20 is configured to generate a white light having a color temperature ranging from approximately 2700K to 7000K, an infrared light having a wavelength ranging from approximately 750 to 1000 nm (e.g., the infrared light having a wavelength ranging from approximately 790 to 830 nm and the peak value of which is 810 nm, a wavelength ranging from approximately 830 to 870 nm and the peak value of which is 850 nm, or a wavelength ranging from approximately 900 to 1000 nm and the peak value of which is 940 nm), or a laser beam having a wavelength ranging from approximately 800 to 1000 nm. In other words, specific examples of the light-emitting element 20 include LED for generating visible light, LED for generating invisible light (e.g., infrared emitting diode, laser diode, and so on.), and laser (e.g., liquid state laser, solid state laser, gas laser element, and so on.), wherein the solid state laser can be a laser diode.

The optical lens 30 can be the curable sealer having the ability to moisture-resistant. The optical lens 30 is mounted on the installation surface 11 of the substrate 10 to encapsulate the light-emitting element 20. To reduce light refraction and loss, the illumination module 1a of the invention is completed by a primary optical design, that is, the optical lens 30 is formed on the installation surface 11 of the substrate 10 by overmolding and fits compactly with the light-emitting element 20 such that the optical lens 30 has no air gap with the substrate 10, and the light-emitting element 20. For the instant embodiment, the curable sealer can be selected from one of the transparent materials such as epoxy, acrylic resin, silicon resin, and silicone, however not restricted thereto.

In more details, the optical lens 30 includes a light-entrance surface 31 and a light-exiting surface 32 opposite to the entrance surface 31. When the length extending direction of the light-entrance surface 31 is an X axial direction, the width extending direction of the light-entrance surface 31 is a Y axial direction which is perpendicular to the X axial direction, and a direction perpendicular to the light-entrance surface 31 is a Z axial direction, the light-exiting surface 32 protrudes from the light-entrance surface 31 to the Z axial direction.

It is worthy to note that the light-exiting surface 32 is formed by at least two curves 33 of different curvature and has a light emission center 35. Thereby, a beam of light generated by the light-emitting element 20 can be directed by the light-exiting surface 32 of the optical lens 30 along the optical axis 34 so as to pass through the light emission center 35 and emit outwards to an illuminated target region 40 to synchronously create a lateral rectangular illumination window 41. It is worth noting that the lateral rectangular illumination window 41 has an aspect ratio between 1.03 and 1.63, preferably 1.33 (equal to 4:3) or an aspect ratio between 1.48 and 2.08, preferably 1.78 (equal to 16:9). Here, the term "aspect ratio" refers to the ratio of the maximum cross-sectional dimension of the illuminated target region 40 with the maximum cross-sectional dimension perpendicular to the maximum cross-sectional dimension.

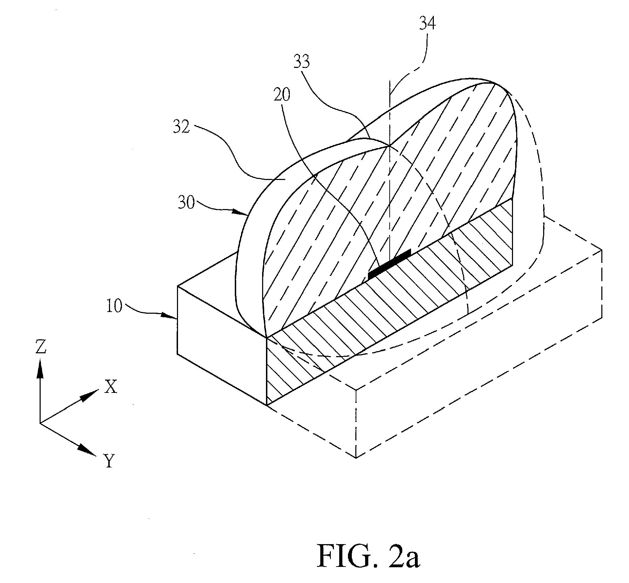

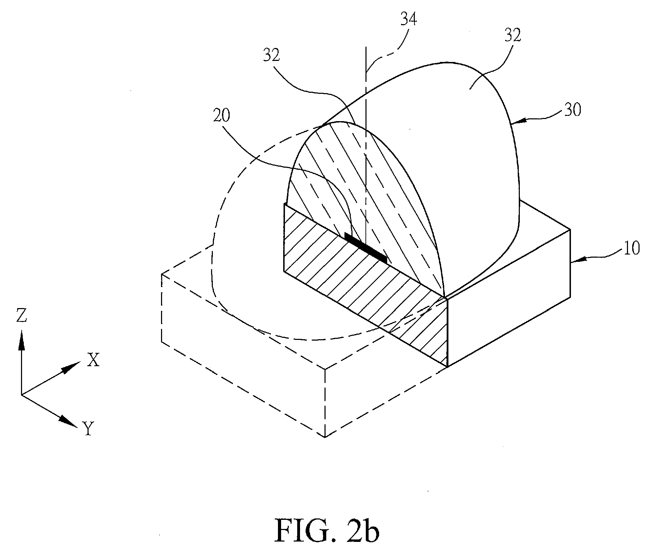

The optical lens 30 is asymmetric. The optical lens 30 is a transparent material. The light-exiting surface 32 of the optical lens 30 can be an aspheric surface, a cambered surface, a paraboloid surface, a hyperboloid surface, or a free-form surface. Please go on to refer FIG. 2a to FIG. 2b, which are sectional views (1) and (2) showing an illumination module for creating specific lateral rectangular illumination window according to the first embodiment of the present invention, wherein FIG. 2a is the sectional view passing through the optical axis 34 and extending toward two sides of the X axial direction, the light-exiting surface 32 protrudes along the two sides of the X axial direction and invaginates to the center, and the profile of the light-exiting surface 32 is approximately an M shape or is an M shape. FIG. 2b is the sectional view, which extends towards orthogonal and perpendicular to the X axial direction. The light-exiting surface 32 protrudes towards the center of the optical axis 34 and the profile of the light-exiting surface 32 extending towards the two sides of the Y axial direction is approximately an arch shape or is an arch shape but not limited to this one. In another embodiment, the profile extending towards the two sides of the Y axial direction is an M shape.

### Second embodiment

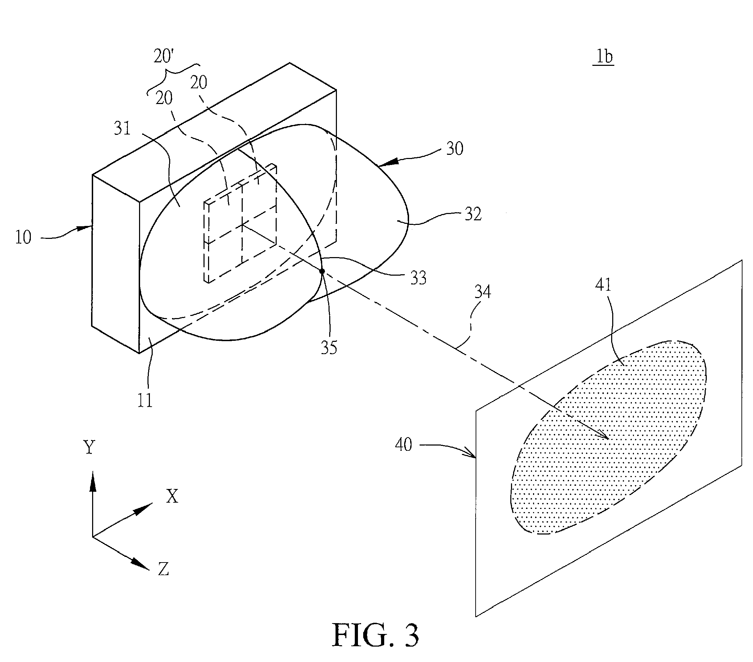

Please refer to FIG. 3. This is a perspective view showing an illumination module for creating specific lateral rectangular illumination window according to a second embodiment of the present invention. The illumination module 1b includes a substrate 10, at least one light-emitting elements 20, and an optical lens 30. The difference between the first embodiment and the second embodiment is that the light-emitting elements 20 are pluralities and are arranged in a non-rectangular illuminate array 20'. For example, as shown in FIG. 3, the illumination module 1b includes four light-emitting elements 20, which are arranged in a square illuminate array 20' with each two light-emitting elements 20 in a row.

Please note that the square illuminate array 20' shown in FIG. 3 consists of four light-emitting elements 20, but embodiments are not limited to any particular number of light-emitting elements 20. In various embodiments, the square illuminate array 20' may include nine light-emitting elements 20, which are arranged in a square illuminate array 20' with each three light-emitting elements 20 in a row, and so on. That is, the amount of the light-emitting elements 20 shown in FIG. 3 is for reference only but not limited to the scope of the invention.

The substrate 10 includes an installation surface 11 for arrangement of the light-emitting element 20. For the instant embodiment, the substrate 10 can be but not limited to a metal substrate, a ceramic substrate, or a glass fiber substrate (e.g., FR-4, FR-5, G-10, G-11, and so on.). Specifically, the metal substrate can be selected from one of the materials including copper, copper alloy, aluminum, aluminum alloy, magnesium alloy, aluminum silicon carbide, and carbon composition. The ceramic substrate can be selected from one of the materials including aluminum oxide, aluminum nitride, zirconium oxide, silicon carbide, hexagonal boron nitride, and fluorinated carbon. Preferably, on a surface opposite to the installation surface 11 of the substrate 10 there can be arranged a heat sink (not shown) to dissipate heat from the light-emitting element 20, wherein the heat sink can be made by die-casting, aluminum extruding, or punching.

The illuminate array 20' is mounted on the substrate 10, and has an optical axis 34, wherein the shape of each light-emitting element 20 is square. For the instant embodiment, the light-emitting element 20 of the illuminate array 20' is configured to generate a white light having a color temperature ranging from approximately 2700K to 7000K, an infrared light having a wavelength ranging from approximately 750 to 1000 nm (e.g., the infrared light having a wavelength ranging from approximately 790 to 830 nm and the peak value of which is 810 nm, a wavelength ranging from approximately 830 to 870 nm and the peak value of which is 850 nm, or a wavelength ranging from approximately 900 to 1000 nm and the peak value of which is 940 nm), or a laser beam having a wavelength ranging from approximately 800 to 1000 nm. In other words, specific examples of the light-emitting element 20 include LED for generating visible light, LED for generating invisible light (e.g., infrared emitting diode, laser diode, and so on.), and laser (e.g., liquid state laser, solid state laser, gas laser element, and so on.), wherein the solid state laser can be a laser diode.

The optical lens 30 can be the curable sealer having the ability to moisture-resistant. The optical lens 30 is mounted on the installation surface 11 of the substrate 10 to encapsulate the light-emitting elements 20. The optical lens 30 has no air gap with the substrate 10 and the light-emitting element 20 with the same manner for encapsulation. For the instant embodiment, the curable sealer can be selected from one of the transparent materials such as epoxy, acrylic resin, silicon resin, and silicone, however not restricted thereto.

In more details, the optical lens 30 includes a light-entrance surface 31 and a light-exiting surface 32 opposite to the entrance surface 31. When a length extending direction of the light-entrance surface 31 is an X axial direction, a width extending direction of the light-entrance surface 31 is a Y axial direction which is perpendicular to the X axial direction, and a direction perpendicular to the light-entrance surface 31 is a Z axial direction, the light-exiting surface 32 protrudes from the light-entrance surface 31 to the Z axial direction.

It is worthy to note that the light-exiting surface 32 is formed by at least two curves 33 of different curvature and has a light emission center 35. Thereby, a beam of light generated by the light-emitting element 20 can be directed by the light-exiting surface 32 of the optical lens 30 along the optical axis 34 so as to pass through the light emission center 35 and emit outwards to an illuminated target region 40 to synchronously create a lateral rectangular illumination window 41. It is worth noting that the lateral rectangular illumination window 41 has an aspect ratio between 1.03 and 1.63, preferably 1.33 (equal to 4:3) or an aspect ratio between 1.48 and 2.08, preferably 1.78 (equal to 16:9). Here, the term "aspect ratio" refers to the ratio of the maximum cross-sectional dimension of the illuminated target region 40 with the maximum cross-sectional dimension perpendicular to the maximum cross-sectional dimension.

The optical lens 30 is asymmetric. The optical lens 30 is a transparent material. The light-exiting surface 32 of the optical lens 30 can be selected from an aspheric surface, a cambered surface, a paraboloid surface, a hyperboloid surface, and a free-form surface.

### Third embodiment

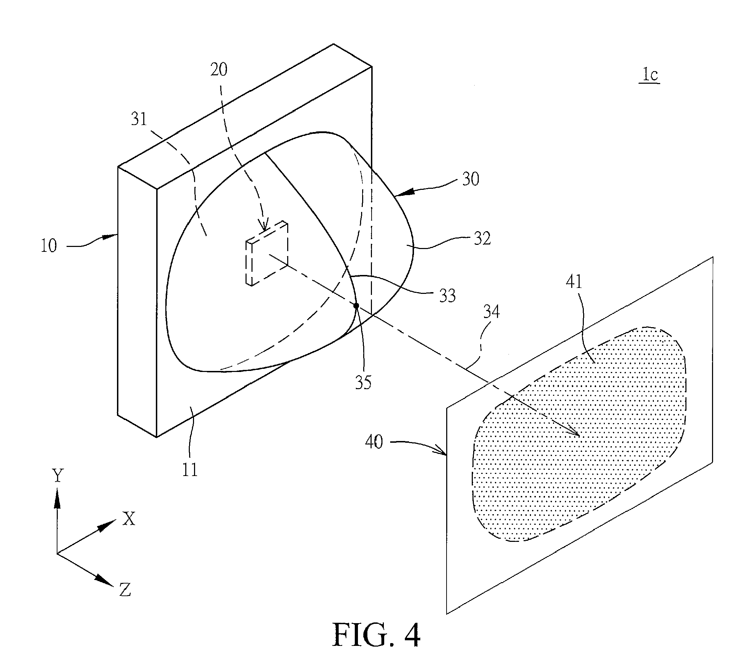

Please refer to FIG. 4, which is a perspective diagram showing an illumination module for creating specific lateral rectangular illumination window according to a third embodiment of the present invention. As shown in FIG. 4, the illumination module 1c includes a substrate 10, a light-emitting element 20, and an optical lens 30. The optical lens 30 includes a light-entrance surface 31 and a light-exiting surface 32 opposite to the entrance surface 31. When a length extending direction of the light-entrance surface 31 is an X axial direction, a width extending direction of the light-entrance surface 31 is a Y axial direction which is perpendicular to the X axial direction, and a direction perpendicular to the light-entrance surface 31 is a Z axial direction, the light-exiting surface 32 protrudes from the light-entrance surface 31 to the Z axial direction. The light-exiting surface 32 of the optical lens 30 can be a free-form surface, or a hyperboloid surface. For the instant embodiment, the shape of the light-emitting element 20 is square and the light-emitting element 20 is configured to generate the infrared light of which wavelength ranging is from approximately 750 to 1000 nm (e.g., the infrared light having a wavelength ranging from 790 to 830 nm and the peak value of which is 810 nm, a wavelength ranging from 830 to 870 nm and the peak value of which is 850 nm, or a wavelength ranging from 900 to 1000 nm and the peak value of which is 940 nm).

In details, the light-exiting surface 32 of the optical lens 30 is formed by at least two curves 33 of different curvature and has a light emission center 35. Thereby, a beam of light generated by the light-emitting element 20 can be directed by the light-exiting surface 32 of the optical lens 30 along the optical axis 34 so as to pass through the light emission center 35 and emit outwards to an illuminated target region 40 to synchronously create a lateral rectangular illumination window 41.

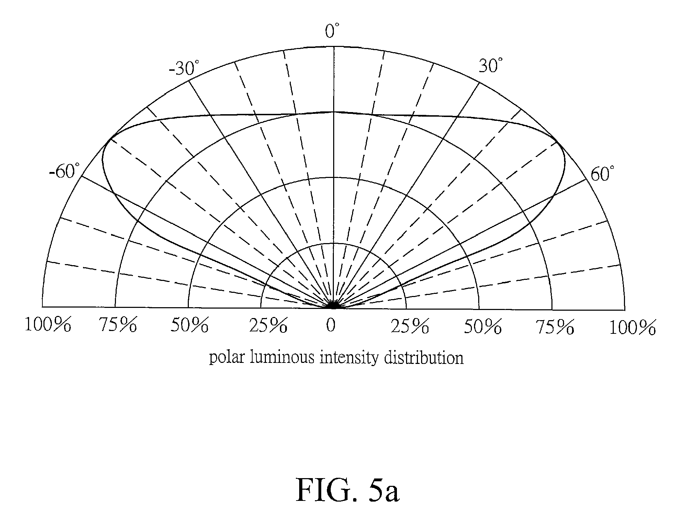

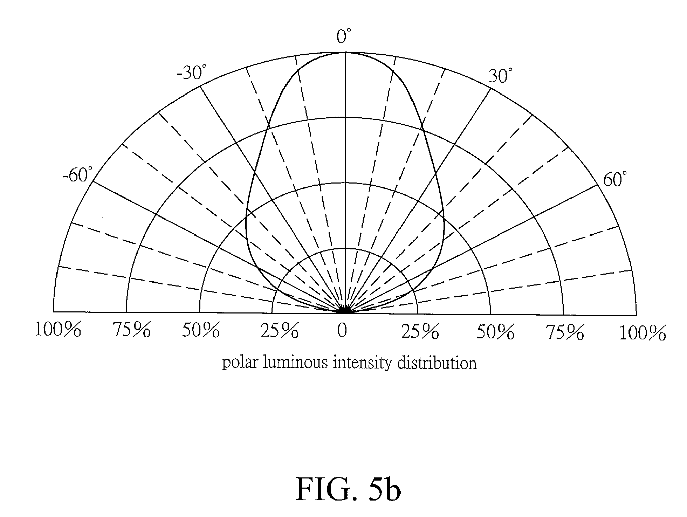

Please refer to FIG. 5a to 5b with FIG. 4, which are polar luminous intensity distribution diagrams (1) and (2) showing an illumination module for creating specific lateral rectangular illumination window according to the third embodiment of the present invention. FIG. 5a is the polar luminous intensity distribution diagram passing through the optical axis 34 in the X axial direction. The light-exiting surface 32 of the optical lens 30 can be a free-form surface, or a hyperboloid surface. The light-emitting element 20 is configured to generate the infrared light wavelength ranging is from 830 to 870 nm and the peak value of which is 850 nm. The light distribution pattern of the light-emitting element 20 is the contour of the bat wings and the half-power angle (the light angle that light intensive value is half of the intensive value of the axis direction) of the light-emitting element 20 is smaller than 160 degrees. Preferably, the half-power angle is smaller than 140 degrees. FIG. 5b is the polar luminous intensity distribution diagram passing through the optical axis 34 and being orthogonal and perpendicular to the X axial direction. The light-exiting surface 32 of the optical lens 30 can be a free-form surface, or a hyperboloid surface. The light-emitting element 20 is configured to generate the infrared light wavelength ranging is from 830 to 870 nm and the peak value of which is 850 nm. The light distribution of the light-emitting element 20 is the contour of the light-concentrating and the half-power angle of the light-emitting element 20 is smaller than 120 degrees. Preferably, the half-power angle is smaller than 100 degrees. Furthermore, the prefer half-power angle in the X axial direction is 130 degrees and the prefer half-power angle in the Y axial direction is 85 degrees but not limited to this one. For example, the light distribution pattern in the light distribution curve diagram orthogonal and perpendicular to the X axial direction is the contour of the bat wings. Therefore, the optical design mentioned above can make the light-emitting element 20 generate the rectangular illumination window with uniform distribution.

Based on the above, the invention is implemented in the surveillance camera system. The invention can create a specific lateral rectangular illumination window having an aspect ratio of between 1.03 and 1.63 or an aspect ratio of between 1.48 and 2.08. Thereby, rectangular images can be directly captured by a camera, and the peripheral of the target object can be clearly shot. In addition, the components of the camera can be reduced, and distortion caused by compressing and converting the image can be prevented.

The descriptions illustrated *supra* set forth simply the preferred embodiments of the instant disclosure; however, the characteristics of the instant disclosure are by no means restricted thereto. All changes, alterations, or modifications conveniently considered by those skilled in the art are deemed to be encompassed within the scope of the instant disclosure delineated by the following claims.

## Claims

1. An illumination module for creating specific lateral rectangular illumination window, comprising:
a substrate having an installation surface;
at least one light-emitting element having an optical axis, and mounted on the installation surface of the substrate; and
an optical lens mounted on the installation surface of the substrate to encapsulate the at least one light-emitting element, wherein the optical lens has no air gap with the substrate and the light-emitting element, is an asymmetric and transparent material, and includes a light-entrance surface and a light-exiting surface opposite to the light-entrance surface, wherein the length extending direction of the light-entrance surface is an X axial direction, the width extending direction of the light-entrance surface is a Y axial direction, which is perpendicular to the X axial direction, and a direction perpendicular to the light-entrance surface is a Z axial direction;
wherein the light-exiting surface is formed by at least two curves of different curvature and has a light emission center, protruded from the light-entrance surface to the Z axial direction, and configured to direct a beam of light generated by the light-emitting element to output along a direction of the optical axis, pass through the light emission center, and emit outwards to create a lateral rectangular illumination window;
wherein the lateral rectangular illumination window has an aspect ratio between 1.03 and 2.08.

2. The illumination module according to claim 1, wherein the aspect ratio is between 1.03 and 1.63 or between 1.48 and 2.08.

3. The illumination module according to claim 1, wherein the light-emitting element is configured to generate a white light having a color temperature ranging from 2700K to 7000K.

4. The illumination module according to claim 1, wherein the light-emitting element is configured to generate an infrared light having a wavelength ranging from 750 to 1000 nm.

5. The illumination module according to claim 4, wherein the light-emitting element is configured to generate the infrared light having a wavelength ranging from 790 to 830 nm, from 830 to 870 nm, or from 900 to 1000 nm.

6. The illumination module according to claim 3, 4 or 5, wherein the light-emitting element is a LED.

7. The illumination module according to claim 1, wherein the light-emitting element is a laser configured to generate a laser beam having a wavelength ranging from 800 to 1000 nm.

8. The illumination module according to claim 7, wherein the laser is a laser diode.

9. The illumination module according to claim 1, wherein an amount of the light-emitting element is at least one, a shape of the light-emitting element is square, the light-emitting elements are arranged in an illuminate array, and a shape of the illuminate array is square.

10. The illumination module according to claim 1, wherein the substrate is a metal substrate, a ceramic substrate, or a glass fiber substrate.

11. The illumination module according to claim 10, wherein the metal substrate is selected from copper, copper alloy, aluminum, aluminum alloy, magnesium alloy, aluminum silicon carbide, and carbon composition.

12. The illumination module according to claim 10, wherein a material of the ceramic substrate is selected from aluminum oxide, aluminum nitride, zirconium oxide, silicon carbide, hexagonal boron nitride, and fluorinated carbon.

13. The illumination module according to claim 1, wherein the light-exiting surface of the optical lens is selected from an aspheric surface, a cambered surface, a paraboloid surface, a hyperboloid surface, and a free-form surface.

14. The illumination module according to claim 13, wherein the light-exiting surface is a free-form surface or a hyperboloid surface, protrudes along two sides of the X axial direction and invaginates to the center of the optical axis, a profile of which is an M shape and the light-exiting surface in the Y axial direction protrudes to the optical axis and extends towards two sides of the Y axial direction, the profile of which is an arch shape or an M shape.

15. The illumination module according to claim 14, wherein the light-exiting surface is a free-form surface or a hyperboloid surface, a half-power angle passing through the optical axis in the X axial direction is smaller than 160 degrees, and a half-power angle passing through the optical axis and being orthogonal and perpendicular to the X axial direction is smaller than 120 degrees.

16. The illumination module according to claim 15, wherein the half-power angle passing through the optical axis in the X axial direction is 130 degrees, and the half-power angle being orthogonal and perpendicular to the X axial direction is 85 degrees.

17. The illumination module according to claim 1 or 13, wherein a material of the optical lens is selected from epoxy, acrylic resin, silicon resin, and silicone.
